(19) Europäisches Patentamt / European Patent Office / Office européen des brevets

(11) **EP 2 202 881 B1**

(12) **EUROPEAN PATENT SPECIFICATION**

(45) Date of publication and mention
of the grant of the patent:
**24.04.2013 Bulletin 2013/17**

(51) Int Cl.:
***H03G 3/32*** *(2006.01)*

(21) Application number: **09252574.0**

(22) Date of filing: **06.11.2009**

(54) **Signal processing apparatus, signal processing method and program**

Signalverarbeitungsvorrichtung, Signalverarbeitungsverfahren und Programm

Appareil de traitement de signaux, procédé de traitement de signaux et programme

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **26.12.2008 JP 2008332031**

(43) Date of publication of application:
**30.06.2010 Bulletin 2010/26**

(73) Proprietor: **Sony Corporation**
**Tokyo 108-0075 (JP)**

(72) Inventors:
• **Watanabe, Hideaki**
**Tokyo 108-0075 (JP)**
• **Fujita, Noriaki**
**Tokyo 108-0075 (JP)**
• **Matsumoto, Jun**
**Tokyo 108-0075 (JP)**

(74) Representative: **Ealey, Douglas Ralph et al**
**D Young & Co LLP**
**120 Holborn**
**London EC1N 2DY (GB)**

(56) References cited:
**WO-A1-2006/047600    DE-A1- 10 052 104**
**US-A1- 2005 015 252**

**Description**

The present invention relates to a signal processing apparatus, to a method for signal processing, and to a program of executing the method on a computer.

In recent years, since new devices such as multichannel TV and DVD (Digital Versatile Disk) have been widely introduced, a wide variety of AV (Audio Visual) content items are reproduced by a recording/reproducing apparatus. In this situation, viewers should manually adjust the output level of an audio signal for each content item because the audio signal levels differ considerably depending on the content items. To address this problem, methods for adjusting the output level of sound for each content item have been invented. For example, a recording/reproducing apparatus capable of automatically adjusting the volume of sound in accordance with a scene included in a content item has been proposed. (Refer to, for example, Fig. 1 in Japanese Unexamined Patent Application Publication No. 2007-53510.)

Furthermore, noise level may differ depending on the viewers' audio-visual environments. Accordingly, viewers should manually adjust the volume of sound output from a recording/reproducing apparatus in response to the noise level. To address this problem, a sound output device capable of detecting the noise level in accordance with the signal captured by a microphone and adjusting the volume of the output sound in accordance with the detected noise level has been proposed. (Refer to, for example, Fig. 1 in Japanese Patent No. 3286981.)

The former of the aforementioned related arts is capable of automatically adjusting the volume of sound in accordance with a scene included in a content item. However, in this case, every time the noise level varies in the viewer's audio-visual environment, the volume should be manually adjusted to address the variation. On the other hand, the latter is capable of adjusting the volume of an output sound in accordance with a noise level in the audio-visual environment. However, if the audio signal level of a content item varies, the volume should be manually adjusted for each content item.

In this way, with related arts, the volume should be manually adjusted regarding ambient noise level and volume of sound of the content item.

The present invention was proposed in the light of these situations; it is desirable to adjust an audio signal level to its optimum output level.

Additionally, document US 2005/0015252 shows a speech correction apparatus including loudness compensation and ambient noise detection.

Document WO 2006/047600 shows a modification of an audio signal based on measurement of loudness and noise.

Various respective aspects and features of the invention are defined in the appended claims. Combinations of features from the dependent claims may be combined with features of the independent claims as appropriate and not merely as explicitly set out in the claims.

According to embodiments of the present invention, there are provided a signal processing apparatus, and more particularly, to a signal processing apparatus capable of automatically controlling the volume of an audio signal, a signal processing method, and a program, which executes signal processing on a computer.

According to the embodiments of the present invention, a superior effect that an audio signal is adjusted to its optimum output level may be obtained.

Embodiments of the invention will now be described with reference to the accompanying drawings, throughout which like parts are referred to by like references, and in which:

> Fig. 1 is a block diagram illustrating a configuration example of a recording/reproducing apparatus according to a first embodiment of the present invention;
> Fig. 2 is a block diagram illustrating a configuration example of a content analysis information generator and an environmental noise analysis information generator according to the first embodiment of the present invention;
> Fig. 3 is a block diagram illustrating a configuration example of an audio adjustment unit according to the first embodiment of the present invention;
> Fig. 4 is a block diagram illustrating a configuration example of an environmental noise separator according to the first embodiment of the present invention;
> Fig. 5 illustrates a data format example of the content analysis information generated by the content analysis information generator according to a second embodiment of the present invention;
> Fig. 6 illustrates a data format example of environmental noise information generated by the environmental noise analysis information generator according to the second embodiment of the present invention;
> Fig. 7 illustrates a method example for calculating a target gain in the audio adjustment unit according to a third embodiment of the present invention;
> Fig. 8 illustrates a method example for adjusting volume by a compressor processing unit according to the third embodiment of the present invention;
> Fig. 9 is a schematic diagram relating to a method example for adjusting the volume by an equalizing processing unit according to the third embodiment of the present invention;

Fig. 10 is a flowchart illustrating a procedure example for processing audio adjustment by a recording/reproducing apparatus according to a fourth embodiment of the present invention; and

Fig. 11 is a flowchart illustrating a procedure example for processing audio adjustment (Step S950) by the audio adjustment unit according to the fourth embodiment of the present invention.

Preferred embodiments (hereinafter referred to as simply embodiments) for carrying out the present invention are described in detail according to the order listed below.

1. First Embodiment (Controlling the volume of audio signals: a configuration example of a recording/reproducing apparatus)

2. Second Embodiment (Controlling the volume of audio signals: the data format example of control information)

3. Third Embodiment (Controlling the sound level of audio signals: a method example of calculating gains)

4. Fourth Embodiment (Controlling the volume of audio signals: a procedure example for controlling the volume)

<1. First Embodiment>

[Configuration example of a recording/reproducing apparatus]

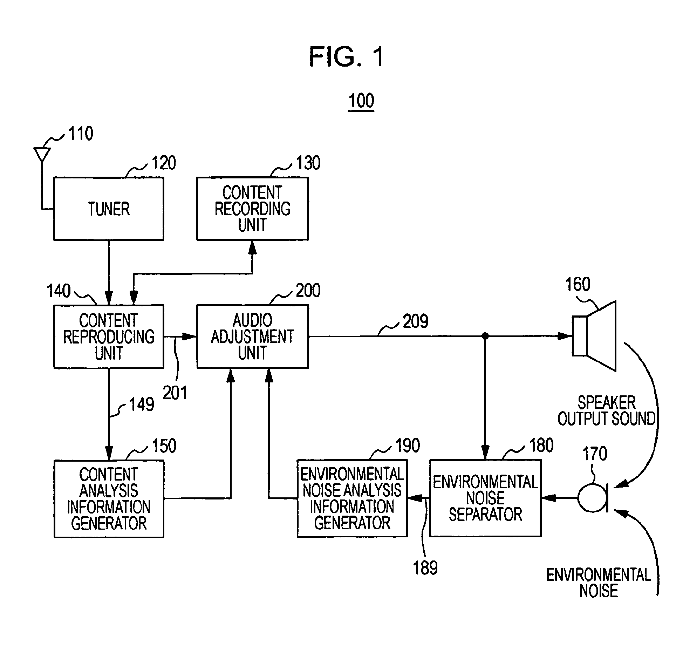

Fig. 1 is a block diagram illustrating a configuration example of a recording/reproducing apparatus according to a first embodiment of the present invention. A recording/reproducing apparatus 100 includes an antenna 110, a tuner 120, a content recording unit 130, a content reproducing unit 140, a content analysis information generator 150, and a speaker 160. Moreover, the recording/reproducing apparatus 100 has a microphone 170, an environmental noise separator 180, an environmental noise analysis information generator 190, and an audio adjustment unit 200.

The antenna 110 is used to receive broadcast signals.

The antenna 110 receives broadcast signals sent by, for example, a ground-based broadcasting system, a broadcasting satellite, and a communication satellite.

The tuner 120 demodulates signals receives by the antenna 110. The tuner 120 supplies content data, which is demodulated, received data to the content reproducing unit 140. The content data herein includes, for example, broadcast content items such as ground-based broadcasting, broadcasting satellite, and communication satellite content items and meta data such as EPG accompanying broadcast content items.

The content recording unit 130 converts the content data supplied from the tuner 120 into a given data format and then records it. The content recording unit 130 supplies the content data recorded therein to the content reproducing unit 140. Herein, an example of recording the content data output from the tuner 120 has been described, but the content data supplied from an external device may be recorded by adding an AV input terminal to the recording/reproducing apparatus 100.

The content reproducing unit 140 reproduces the content data supplied from the tuner 120 or the content recording unit 130. The content reproducing unit 140 demodulates, for example, sound data supplied from the tuner 120 to generate audio signals. The content reproducing unit 140 demodulates the picture data included in AV content data from the content recording unit 130 and the sound data corresponding to the picture data to generate picture and audio signal.

Moreover, the content reproducing unit 140 supplies the demodulated audio signals to the content analysis information generator 150 and the audio adjustment unit 200 via signal lines 149 and 201. The content reproducing unit 140 supplies, for example, picture and meta data in addition to the demodulated audio signals. Furthermore, the content reproducing unit 140 demodulates the content data supplied from the tuner 120 and then supplies the demodulated content data to the content recording unit 130.

The content analysis information generator 150 analyzes the content data supplied from the content reproducing unit 140 to generate the content analysis information on audio signals reproduced at the content reproducing unit 140. The content analysis information generator 150 generates the content analysis information for each frame in accordance with the audio signals supplied from the content reproducing unit 140. Herein, the frame is a certain number of samples obtained from audio signals. The content analysis information generator 150 generates the content analysis information in accordance with the frequency characteristic of audio signals supplied from the content reproducing unit 140.

The content analysis information generator 150 determines, for example, the kinds (CM (Commercial Message)/ news program) of scenes in the content items and supplies the result of determination to the audio adjustment unit 200 as the content analysis information. In this embodiment, the content analysis information generator 150 detects scenes according to temporal responses such as luminance information of picture signals in a content item. Moreover, the content analysis information generator 150 combines the result of detection and information such as EPG (Electric Program Guide) data to determine the kinds of scenes.

The content analysis information generator 150 supplies the generated content analysis information to the audio adjustment unit 200. The content analysis information generator 150 is an example of the first audio adjustment information generator according to an embodiment of the present invention. The content analysis information is an example of first audio adjustment information according to the embodiment.

The speaker 160 is a loud speaker, which outputs the audio signals supplied from the audio adjustment unit 200 as output sound. The speaker 160 is an example of a sound output unit according to an embodiment of the present invention.

The microphone 170 is a microphone, which captures the ambient sound surrounding the recording/reproducing apparatus 100. The microphone 170 converts the captured ambient sound into electric signals and supplies them to the environmental noise separator 180 as noise signals. The noise signals include the output sound output from the speaker 160 and any other environmental noises. The microphone 170 is an example of a sound input unit according to an embodiment of the present invention.

The environmental noise separator 180 cancels the output sound output from the speaker 160 included in the noise signals in accordance with the noise signals supplied from the microphone 170 and the audio signals supplied from the audio adjustment unit 200. Specifically, the environmental noise separator 180 separates the audio signal component output from the speaker 160 and the noise signal component, that is, the environmental noise signal component, supplied from the microphone 170.

The environmental noise separator 180 calculates similarity between the audio signal supplied from the audio adjustment unit 200 and the output sound included in the noise signal in accordance with the audio signal supplied from the audio adjustment unit 200, and estimates the environmental noise signal in accordance with the calculated similarity. The environmental noise separator 180 is formed by, for example, an echo canceller. The environmental noise separator 180 supplies the separated environmental noise signal to the environmental noise analysis information generator 190 via a signal line 189. The environmental noise separator 180 is an example of an audio separator according to an embodiment of the present invention.

The environmental noise analysis information generator 190 analyzes the environmental noise signal supplied from the environmental noise separator 180 to generate the environmental noise analysis information about the environmental noise signal. The environmental noise analysis information generator 190 generates the environmental noise analysis information in accordance with the environmental noise signal supplied from the environmental noise separator 180. The environmental noise analysis information generator 190 generates the environmental noise analysis information in accordance with, for example, the signal level of the environmental noise signal supplied from the environmental noise separator 180. Moreover, the environmental noise analysis information generator 190 supplies the generated environmental noise analysis information to the audio adjustment unit 200. The environmental noise analysis information generator 190 is an example of the second audio adjustment information generator according to an embodiment of the present invention. The environmental noise analysis information is an example of second audio adjustment information according to the embodiment.

The audio adjustment unit 200 adjusts the volume of the audio signal supplied from the content reproducing unit 140 in accordance with the content analysis information from the content analysis information generator 150 and the environmental noise analysis information from the environmental noise analysis information generator 190. The audio adjustment unit 200 supplies the adjusted audio signal to the speaker 160 and the environmental noise separator 180 via a signal line 209. The audio adjustment unit 200 is an example of the audio adjustment unit according to an embodiment of the present invention.

[Configuration example of the content analysis information generator and the environmental noise analysis information generator]

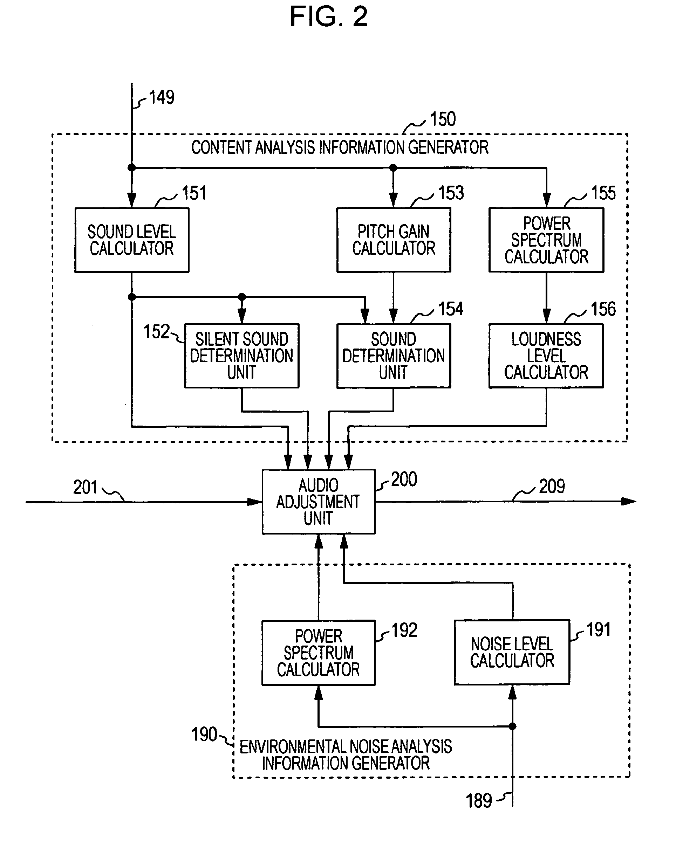

Fig. 2 is a block diagram illustrating a configuration example of the content analysis information generator 150 and the environmental noise analysis information generator 190 according to the first embodiment of the present invention. Herein, a description of the audio adjustment unit 200, which is the same unit as that shown in Fig. 1, is omitted by assigning the same reference numeral to it.

The content analysis information generator 150 includes a sound level calculator 151, a silent sound determination unit 152, a pitch gain calculator 153, a sound determination unit 154, a power spectrum calculator 155, and a loudness level calculator 156. The environmental noise analysis information generator 190 has a noise level calculator 191 and a power spectrum calculator 192.

The sound level calculator 151 calculates the signal level of the audio signal supplied via the signal line 149 for each frame. The sound level calculator 151 calculates the signal level, which is a root mean square (power value) of sampled values for each frame of the audio signal, as the sound level. The sound level calculator 151 supplies the calculated sound level to the silent sound determination unit 152 and the sound determination unit 154, and the audio adjustment unit 200.

The silent sound determination unit 152 determines whether the audio signal supplied from the sound level calculator 151 is a silent sound in accordance with the sound level thereof. The silent sound determination unit 152 determines whether the audio signal is a silent sound in accordance with the sound level from the sound level calculator 151 and a pre-determined threshold Ts (sound level threshold) and then, in accordance with the result of determination, generates silent sound determination information. The silent sound determination unit 152 generates, for example, the silent sound determination information (Silence Flag=True) indicating the silent sound if the sound level is lower than the threshold. On the other hand, the silent sound determination unit 152 generates the silent sound determination information (Silence Flag=False) indicating non-silent sound if the sound level is equal to or higher than the threshold. The silent sound determination unit 152 supplies the generated silent sound determination information to the audio adjustment unit 200 as the content analysis information. The silent sound determination unit 152 is an example of the silent sound determination unit according to an embodiment of the present invention.

The pitch gain calculator 153 analyzes the audio signal supplied via the signal line 149 to calculate a pitch gain. Herein, the pitch gain is an index for the strength of a pitch component indicating one of the features of human voice. The pitch gain calculator 153 calculates the pitch gain for each frame in accordance with the periodicity of the audio signal supplied via the signal line 149. The pitch gain calculator 153 supplies the calculated pitch gain to the sound determination unit 154.

The sound determination unit 154 determines whether the audio signal from the content reproducing unit 140 is non-silent sound or silent sound in accordance with the sound level supplied from the sound level calculator 151 and the pitch gain supplied from the pitch gain calculator 153. Specifically, the sound determination unit 154 determines whether or not the audio signal is non-silent sound in accordance with the periodicity thereof in a time domain and the signal level thereof. The sound determination unit 154 generates the sound determination information in accordance with the result of determination.

The sound determination unit 154 generates, for example, the sound determination information indicating the non-silent sound if the sound level is equal to or higher than the threshold Ts (sound level threshold) and the pitch gain is equal to or higher than a given threshold Tp (pitch gain threshold). In any other cases, the sound determination unit 154 generates the sound determination information indicating silent sound. The sound determination unit 154 stores the feature values of the audio signal corresponding to the sound level and the pitch gain to obtain the feature values of the audio signal corresponding to the sound level from the sound level calculator 151 and the pitch gain from the pitch gain calculator 153 later. The sound determination unit 154 generates the sound determination information indicating non-silent sound if the feature value of the audio signal is equal to or higher than a predetermined threshold Tf (feature value threshold), while it generates the sound determination information indicating silent sound if the feature value is lower than the threshold. Moreover, the sound determination unit 154 supplies the generated sound determination information to the audio adjustment unit 200 as the content analysis information. The sound determination unit 154 is an example of the sound determination unit according to an embodiment of the present invention.

The power spectrum calculator 155 calculates the power spectrum of the audio signal in accordance with the frequency characteristic of the audio signal supplied via the signal line 149. The power spectrum calculator 155 supplies the calculated power spectrum to the loudness level calculator 156.

The loudness level calculator 156 calculates a loudness level in accordance with the power spectrum supplied from the power spectrum calculator 155. Herein, the loudness level is an index for sound magnitude considering human auditory characteristics. Specifically, the loudness level calculator 156 calculates the loudness level in accordance with the frequency characteristic of the audio signal and the human auditory characteristics.

The loudness level calculator 156 calculates the loudness level in accordance with, for example, provisions stipulated in ISO (International Organization for Standardization) 532B. In this example, the loudness level calculator 156 generates a masking curve corresponding to the power of the audio signal for each critical band. Moreover, the loudness level calculator 156 calculates an area where a plurality of the generated masking curves is overlapped to further calculate the loudness level. Furthermore, the loudness level calculator 156 supplies the calculated loudness level to the audio adjustment unit 200 as the content analysis information. The loudness level calculator 156 is an example of the first audio adjustment information generator according to an embodiment of the present invention.

The noise level calculator 191 calculates the signal level of the environmental noise signal supplied via the signal line 189 for each frame. The noise level calculator 191 calculates the signal level of the environmental noise signal, which is a root mean square (power value) of sampled values from each frame, as the noise level. The noise level calculator 191 supplies the calculated noise level to the audio adjustment unit 200 as the environmental noise analysis information. The noise level calculator 191 is an example of a second audio adjustment information generator according to an embodiment of the present invention.

The power spectrum calculator 192 calculates the power spectrum of the environmental noise signal in accordance with the frequency characteristic of the environmental noise signal supplied via the signal line 189. The power spectrum calculator 192 supplies the calculated power spectrum to the audio adjustment unit 200 as the environmental noise analysis information.

[Configuration example of the audio adjustment unit]

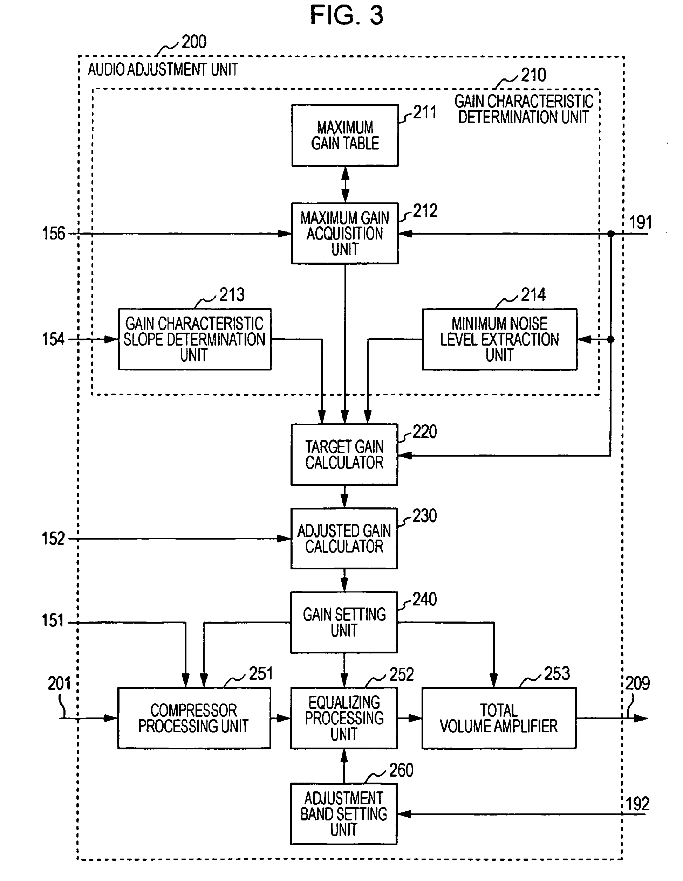

Fig. 3 is a block diagram illustrating a configuration example of the audio adjustment unit 200 according to the first embodiment of the present invention.

The audio adjustment unit 200 includes a gain characteristic determination unit 210, a target gain calculator 220, an adjusted gain calculator 230, a gain setting unit 240, a compressor processing unit 251, a equalizing processing unit 252, a total volume amplifier 253, and an adjustment band setting unit 260.

The gain characteristic determination unit 210 determines the gain characteristic used in calculating the increased amount of the volume of the audio signal in accordance with the content analysis information and the environmental noise analysis information. The gain characteristic determination unit 210 determines the gain characteristic in accordance with the loudness level from the loudness level calculator 156, the sound determination information from the sound determination unit 154, and the noise level from the noise level calculator 191. The gain characteristic determination unit 210 includes a maximum gain table 211, a maximum gain acquisition unit 212, a gain characteristic slope determination unit 213, and a minimum noise level extraction unit 214.

The maximum gain table 211 keeps the maximum gain in the gain characteristic corresponding to the loudness level and the noise level of the audio signal. The maximum gain in the gain characteristic, which is an upper limit value in the gain characteristic, is incorporated to prevent the audio signal from being excessively amplified. The maximum gain table 211 outputs the maximum gain corresponding to the loudness level and the noise level of the audio signal from the maximum gain acquisition unit 212 to the unit 212.

The maximum gain table 211 outputs the maximum gain with a smaller value when the loudness level of the audio signal is higher for viewers to easily detect the audio signal, and outputs the maximum gain with a larger value when the loudness level of the audio signal is lower to hardly detect the audio signal. On the other hand, the maximum gain table 211 outputs the maximum gain with a larger value when the noise level is higher to address the larger environmental noise, and outputs the maximum gain with a smaller value when the noise level is lower because of smaller environmental noise. Specifically, the maximum gain table 211 outputs the maximum gain with a smaller value at the higher loudness level of the audio signal, and outputs the maximum gain with a larger value at the higher noise level of audio signal.

The maximum gain acquisition unit 212 acquires the maximum gain in the gain characteristic in accordance with the loudness level supplied from the loudness level calculator 156 and the noise level supplied from the noise level calculator 191. The maximum gain acquisition unit 212 supplies the loudness level from the loudness level calculator 156 and the noise level from the noise level calculator 191 for each frame to the maximum gain table 211. Moreover, the maximum gain acquisition unit 212 acquires the maximum gain corresponding to the loudness level from the loudness level calculator 156 and the noise level from the noise level calculator 191 from the maximum gain table 211. Furthermore, the maximum gain acquisition unit 212 supplies the acquired maximum gain to the target gain calculator 220. The maximum gain acquisition unit 212 is an example of the audio adjustment unit according to an embodiment of the present invention.

Herein, an example of acquiring the maximum gain in accordance with the loudness level of the audio signal has been described, but it may be acquired in accordance with the sound level of the audio signal instead of the loudness level of the audio signal. In addition, an example of acquiring the maximum gain in accordance with the noise level of the environmental noise signal, but it may be acquired by generating the loudness level of the environmental noise signal at the environmental noise analysis information generator 190, instead of the noise level, and using it in maximum gain acquisition.

The gain characteristic slope determination unit 213 determines the slope in the gain characteristic in accordance with the sound determination information supplied from the sound determination unit 154. The gain characteristic slope determination unit 213 makes the gain characteristic slope larger when the sound determination information indicates non-silent sound than when it indicates silent sound.

The gain characteristic slope determination unit 213 stores, for example, the gain characteristic slope and selects the gain characteristic slope with a larger value when the sound determination information indicates non-silent sound than when it indicates silent sound. On the other hand, the gain characteristic slope determination unit 213 selects the gain characteristic slope with a smaller value when the sound determination information indicates silent sound than when it indicates non-silent sound. Moreover, the gain characteristic slope determination unit 213 supplies the slope in the selected gain characteristic to the target gain calculator 220. The gain characteristic slope determination unit 213 is an example of the audio adjustment unit according to an embodiment of the present invention. Herein, an example of determining the gain characteristic slope in accordance with the sound determination information has been described, but it may be determined according to the kind of the scene of the content item to be reproduced.

The minimum noise level extraction unit 214 extracts the minimum noise level of the noise levels for each frame supplied from the noise level calculator 191. The minimum noise level extraction unit 214 extracts, for example, the minimum noise level, which is the minimum noise level in a given period, and retains the minimum noise level as a new minimum noise level when the extracted minimum noise level is lower than those previously extracted. The minimum noise level extraction unit 214 supplies the extracted minimum noise level to the target gain calculator 220 as background noise level.

The target gain calculator 220 calculates the target gain in accordance with the noise level from the noise level calculator 191 by using the maximum gain, slope, and background noise level in the gain characteristic supplied from the gain characteristic determination unit 210. The target gain calculator 220 generates the gain characteristic by using the maximum gain from the maximum gain acquisition unit 212, the slope from the gain characteristic slope determination unit 213, and the background noise level from the minimum noise level extraction unit 214. The target gain calculator 220 calculates the target gain corresponding to the noise level in the generated gain characteristic from the noise level calculator 191. Furthermore, the target gains calculator 220 supplies the calculated target gain to the adjusted gain calculator 230.

The adjusted gain calculator 230 calculates the adjusted gain in accordance with the target gain to suppress unnatural increase and decrease in volume of the audio signal. The adjusted gain calculator 230 calculates the adjusted gain in accordance with the target gain supplied from the target gain calculator 220 and the silent sound determination information supplied from the silent sound determination unit 152. The adjusted gain calculator 230 calculates the adjusted gain (eq_gain[m]) by a formula 1 if the silent sound determination information indicates non-silent sound and the target gain (target_gain[m]) is larger than the adjusted gain (eq_gain[m-1]) for the previous frame.
In any other cases, the adjusted gain calculator 230 calculates the adjusted gain (eq_gain[m]) by a formula 2.

$$eq\_gain[m] = t1 \cdot target\_gain[m] + (1-t1) \cdot eq\_gain[m-1] \quad \ldots$$

Formula 1

$$eq\_gain[m] = t2 \cdot eq\_gain[m-1] \quad \ldots \quad Formula\ 2$$

Where, t1 and t2 are constants; t1 is set to a larger value than "0.0", and t2 to a lower value than "1.0".

If it is determined from formula 1 that the audio signal in the current frame is not silent sound, and the volume of the audio signal is increased when compared with the previous frame, the volume of the audio signal of non-silent sound may be suppressed from rapidly increasing from that in the previous frame. If it is determined by formula 2 that the audio signal in the current frame is silent sound, the volume of the audio signal of silent sound may be prevented from unnaturally increasing by adjusting the volume in accordance with the volume in the previous frame regardless of the target gain. If the volume is decreased from that in the previous frame, it is suppressed from rapidly decreasing from that in the previous frame. The adjusted gain calculator 230 supplies the calculated adjusted gain to the gain setting unit 240. The adjusted gain calculator 230 is an example of the audio adjustment unit according to an embodiment of the present invention.

The gain setting unit 240 sets the gains of the compressor processing unit 251, the equalizing processing unit 252, and the total volume amplifier 253 in accordance with the adjusted gain supplied from the adjusted gain calculator 230.

The gain setting unit 240 sets the gain for only the compressor processing unit 251 to amplify the audio signal if the adjusted gain supplied from the adjusted gain calculator 230 is equal to or lower than a given threshold Ta (compressor processing threshold). Moreover, the gain setting unit 240 sets the gain for the compressor processing unit 251 and the equalizing processing unit 252 to amplify the audio signal if the adjusted gain is higher than the threshold Ta and equal to or lower than a given threshold Tb (equalizing processing threshold). The gain setting unit 240 sets the gain for the compressor processing unit 251, the equalizing processing unit 252, and the total volume amplifier 253 to amplify the audio signal if the adjusted gain is higher than the threshold Tb.

The compressor processing unit 251 corrects the sound pressure of the audio signal in accordance with the sound level supplied from the sound level calculator 151. The compressor processing unit 251 amplifies the audio signal supplied via the signal line 201 in accordance with the gain set by the gain setting unit 240 and the sound level supplied from the sound level calculator 151. The compressor processing unit 251 modifies, for example, the amplification factor for the volume of the audio signal in accordance with the sound level supplied from the sound level calculator 151. Moreover, the compressor processing unit 251 supplies the amplified audio signal to the equalizing processing unit 252.

The equalizing processing unit 252 amplifies the frequency component of the audio signal in accordance with the frequency band of the environmental noise signal. The equalizing processing unit 252 further amplifies the audio signal amplified by the compressor processing unit 251 in accordance with the gain set the gain setting unit 240 and the maximum frequency set by the adjustment band setting unit 260. Moreover, the equalizing processing unit 252 supplies the amplified audio signal to the total volume amplifier 253.

The total volume amplifier 253 further amplifies the audio signal amplified by the equalizing processing unit 252 in accordance with the gain set by the gain setting unit 240. The total volume amplifier 253 supplies the amplified audio signal to the signal line 209.

An adjustment band setting unit 260 sets the frequency band of the audio signal, of which volume is to be adjusted in the equalizing processing unit 252, in accordance with the power spectrum of the environmental noise signal supplied from the power spectrum calculator 192. The adjustment band setting unit 260 calculates, for example, a spectral centroid in accordance with the power spectrum.

Moreover, the adjustment band setting unit 260 calculates the maximum frequency, which is the upper limit of the band, in which the audio signal is to be amplified, by multiplying the calculated spectral centroid by a pre-determined value. Herein, the spectral centroid is the frequency corresponding to the centroid of the power spectrum in the environmental noise signal. Furthermore, the adjustment band setting unit 260 sets the set maximum frequency in the equalizing processing unit 252.

As described above, by incorporating the maximum gain acquisition unit 212, the maximum gain may be set in accordance with the loudness level of the audio signal and the noise level of the environmental noise signal. By incorporating the gain characteristic slope determination unit 213, the magnitude of the slope of the gain characteristic may be set in accordance with the sound determination information. By incorporating the adjusted gain calculator 230, the volume of silent sound may be prevented from unnaturally increasing, as well as suppressed from rapidly increasing and decreasing. By incorporating the maximum noise level extraction unit 214, the appropriate gain characteristic may be generated according to the environments of different background noise levels.

[Configuration example of the environmental noise separator]

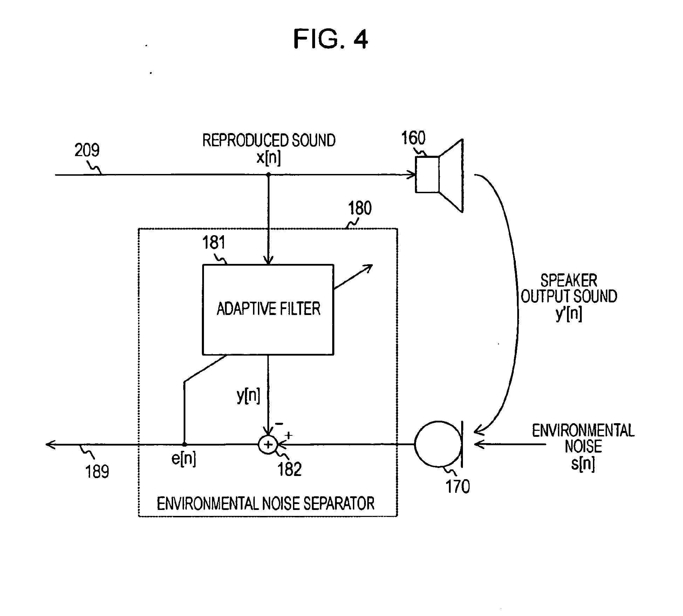

Fig. 4 is a block diagram illustrating a configuration example of the environmental noise separator 180 according to the first embodiment of the present invention. In this drawing, the speaker 160, the microphone 170, and the environmental noise separator 180 are shown. Wherein, it is assumed that one of sampled values of the reproduced sound supplied via the signal line 209 is x[n], the output sound of the sampled value x[n] output from the speaker 160 is y'[n], and the environmental noises other than the output sound y'[n] is s[n]. Accordingly, the noise signal supplied from the microphone 170 is obtained by a formula y'[n]+s[n]. The descriptions of the speaker 160 and the microphone 170, which are the same as those in Fig. 1, are omitted by assigning the same reference numerals.

The environmental noise separator 180 includes an adaptive filter 181 and a subtracter 182. The adaptive filter 181 estimates an output sound component y[n] included in the noise signal from the microphone 170 in accordance with the reproduced sound x[n] from the signal line 209. The adaptive filter 181 superimposes the impulse response in a room acoustic communication system, which may be estimated in accordance with the feedback signal from the subtracter 182 to estimate the output sound component y[n].

The subtracter 182 calculates the difference between the noise signal (y'[n]+s[n]) supplied from the microphone 170 and the output sound component y[n] estimated by the adaptive filter 181. The subtracter 182 subtracts the output sound component y[n] estimated by the adaptive filter 181 from the noise signal (y'[n]+s[n]) supplied from the microphone 170 to generate an environmental noise signal e[n]. The subtracter 182 supplies the generated environmental noise signal e[n] to the adaptive filter 181, as well as the environmental noise analysis information generator 190 via the signal line 189.

As described above, by incorporating the adaptive filter 181 and the subtracter 182, the output sound component included in the noise signal supplied from the microphone 170 may be cancelled to extract the environmental noise signal e[n].

<2. Second Embodiment>

[Data format example of the content analysis information]

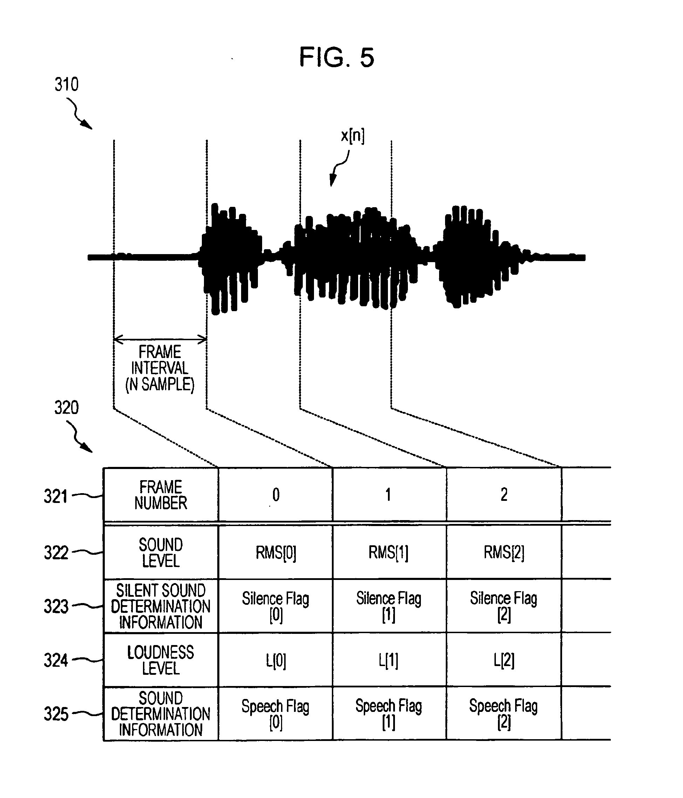

Fig. 5 illustrates a data format example of the content analysis information generated by the content analysis information generator 150 according to a second embodiment of the present invention. In this figure, a reproduced audio signal 310 and the data format of content analysis information 320 are shown. In this drawing, a horizontal axis is a time axis.

The reproduced audio signal 310 indicates variations in amplitude of the audio signal reproduced by the content reproducing unit 140. The reproduced audio signal 310 is formed, assuming that N continuous samples constitute one frame. The reproduced audio signal 310 is analyzed for each frame by the content analysis information generator 150. The reproduced sound x[n] is a value of the amplitude of one sample in one frame.

The content analysis information 320 is a schematic diagram, which shows the data format of the content analysis information for the reproduced audio signal 310 generated for each frame in the content analysis information generator 150. The content analysis information 320 includes a frame number 321, a sound level 322, silent sound determination information 323, a loudness level 324, and sound determination information 325.

The frame number 321 includes the number identifying a frame of the reproduced audio signal 310. The sound level 322 includes the value for the root mean square (RMS[m]) in one frame of the reproduced audio signal 310, which is calculated in the sound level calculator 151.

The silent sound determination information 323 includes the result (Silence Flag[m]) of determination whether or not the reproduced audio signal 310 is silent sound in the silent sound determination unit 152. The silent sound determination information 323 includes "True" when, for example, the reproduced audio signal 310 is determined to be silent sound by the silent sound determination unit 152 and includes "False" when it is determined to be not silent sound.

The loudness level 324 includes a value (L[m]) for the loudness level calculated in the loudness level calculator 156. The loudness level 324 indicates the magnitude of the sound considering human auditory characteristics. Accordingly, viewers are easy to detect the reproduced audio signal 310 output from the speaker 160 at a larger value for the loudness level 324, while difficult to detect the reproduced audio signal 310 output from the speaker 160 at a lower value for the loudness level 324.

The sound determination information 325 includes the result (Speech Flag[m]) of determination whether the reproduced audio signal 310 is non-silent sound or silent sound in the sound determination unit 154.

As described above, the content analysis information 320 generated by the content analysis information generator 150 is supplied to the audio adjustment unit 200.

[Data format example of the environmental noise analysis information]

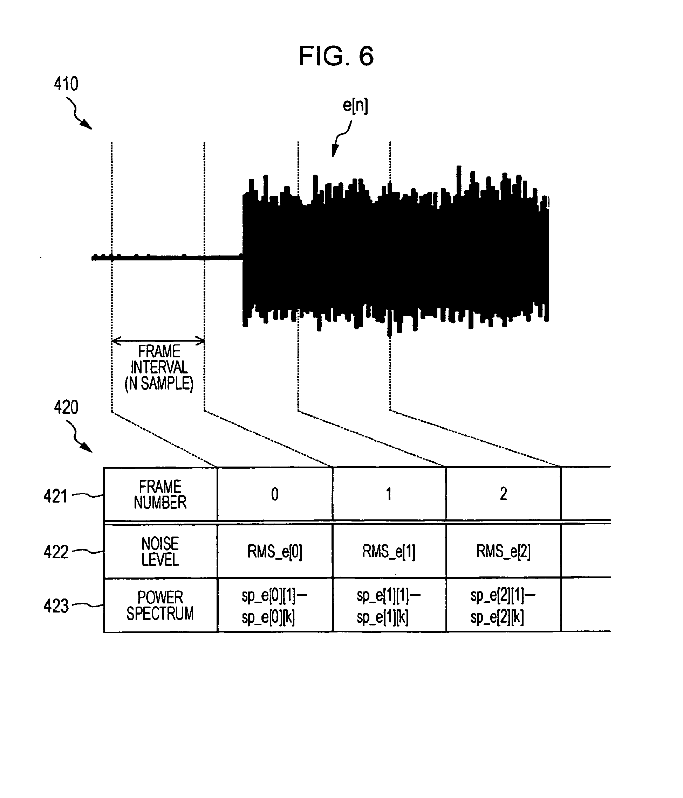

Fig. 6 illustrates a data format example of environmental noise information generated by the environmental noise analysis information generator 190 according to the second embodiment of the present invention. In this drawing, the data formats of an environmental noise signal 410 and environmental noise analysis information 420. In this drawing, a horizontal axis is a time axis.

The environmental noise signal 410 indicates variations in amplitude of the environmental noise signal separated by the environmental noise separator 180. The noise signal 410 is formed, assuming that a series of N samples constitutes one frame. The environmental noise signal 410 is analyzed for each frame by the environmental noise analysis information generator 190. The environmental noise signal e[n] is a value of the amplitude of one sample in one frame.

The environmental noise analysis information 420 is a schematic diagram, which shows the data format of the environmental noise analysis information for the environmental noise signal 410 generated for each frame in the environmental noise analysis information generator 190. The environmental noise analysis information 420 includes a frame number 421, a noise level 422, and a power spectrum 423.

The frame number 421 includes a number identifying a frame for the environmental noise signal 410. The noise level 422 includes a value (RMS_e[m]) for the root mean square of the environmental noise signal 410 calculated in the noise level calculator 191. The power spectrum 423 includes values (sp_e[m][1]-[m][k]) for k power spectra calculated in the power spectrum calculator 192. k is half of N samples.

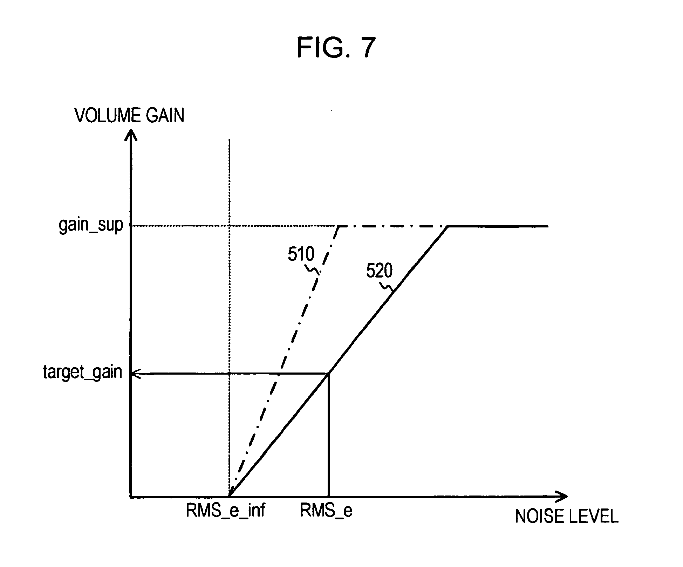

As described above, the environmental noise analysis information 420 generated by the environmental noise analysis information generator 190 is supplied to the audio adjustment unit 200. Next, a method for calculating the target gain in accordance with the environmental noise analysis information 420 and the content analysis information 320, referring to Fig. 7.

<3. Third Embodiment>

[Method example of calculating the target gain]

Fig. 7 illustrates a method example for calculating a target gain in the audio adjustment unit 200 according to a third embodiment of the present invention. In this drawing, gain characteristics 510 and 520 are shown. In this drawing, the vertical axis indicates the gain in the volume of the audio signal and the horizontal axis indicates the noise level.

The maximum gain (gain_sup) is the maximum gain in the gain characteristic acquired in the maximum gain acquisition unit 212. The maximum gain (gain_sup) is determined in accordance with the loudness level (L) of the audio signal and the noise level (RMS_e) of the environmental noise signal in the maximum gain acquisition unit 212. The maximum gain (gain_sup) becomes larger as the noise level (RMS_e) increases and becomes smaller as the noise level (RMS_e) decreases. On the other hand, viewers are made easier to detect the audio signal at a higher loudness level (L) of the audio signal, resulting in a smaller maximum gain (gain_sup). In contrast, viewers are more difficult to detect the audio signal at a lower loudness level (L), resulting in a larger maximum gain (gain_sup).

The background noise level (RMS_e_inf) is a minimum noise level extracted by the minimum noise level extraction unit 214. The background noise level (RMS_e_inf) is set by extracting the minimum noise level from the noise levels (RMS_e) in each frame in the minimum noise level extraction unit 214. Accordingly, the gain characteristic is generated according to the environments with different background noise level (RMS_e_inf).

The slopes of the gain characteristics 510 and 520 are predetermined by the gain characteristic slope determination unit 213 in accordance with the sound determination information (Speech Flag).

As described above, by determining the maximum gain (gain_sup), the background noise level (RMS_e_inf), and the slopes of the gain characteristics 510 and 520, the gain characteristics 510 and 520 are determined.

The gain characteristic 510 is used when the sound determination information (Speech Flag) indicates non-silent sound. The gain characteristic 510 has a characteristic with a larger slope than that of the gain characteristic 520. Accordingly, viewers may be made easier to detect the audio signal when the audio signal indicates non-silent sound.

The gain characteristic 520 is used when the sound determination information (Speech Flag) indicates silent sound. For example, when the sound determination information (Speech Flag) indicates silent sound, the target gains (target_gain) corresponding to the noise level (RMS_e) is calculated in accordance with the gain characteristic 520.

As described above, the maximum gain is determined in accordance with the loudness level (L) of the audio signal and the noise level (RMS_e) of the environmental noise signal; thereby, the target gain becomes smaller at a higher loudness level (L) and larger at a higher noise level (RMS_e). Specifically, the recording/reproducing apparatus 100 suppresses the increased amount of the output sound level if the audio signal output from the speaker 160 has a characteristic of easiness to detect and increases the increased amount of the output sound level if the level of the environmental noise from the microphone 170 is high.

The slope of the gain characteristic is selected in accordance with the sound determination information; thereby, the target gain becomes larger when the sound determination information indicates non-silent sound and becomes smaller when it indicates silent sound. Specifically, the recording/reproducing apparatus 100 increases the output sound level compared with that for silent sound when the audio signal output from the speaker 160 is non-silent sound for viewers to make easier to detect the audio signal.

[Method example for adjusting the volume by the compressor processing unit]

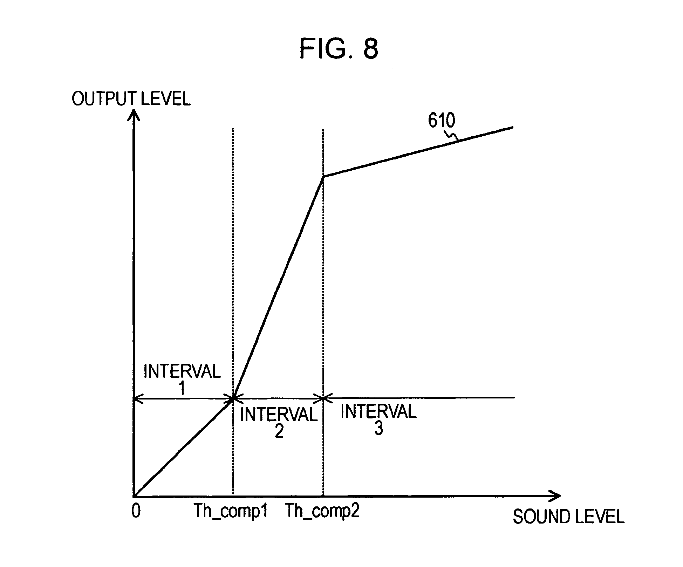

Fig. 8 illustrates a method example for adjusting volume by the compressor processing unit 251 according to the third embodiment of the present invention. In this drawing, a gain correction characteristic 610 is shown. In this drawing, a horizontal axis indicates the sound level (RMS) calculated by the content analysis information generator 150 and the vertical axis indicates the sound output level of the audio signal amplified by the compressor processing unit 251.

The gain correction characteristic 610 is an embodiment of the gain characteristic used in correcting the increase rate of the volume of the audio signal reproduced by the content reproducing unit 140 in accordance with the sound level (RMS) calculated by the content analysis information generator 150. The gain correction characteristic 610 has different increase rate at intervals 1 to 3.

In this case, the compressor processing unit 251 does not correct the gain because the sound level (RMS) of the audio signal is very low when it is lower than the threshold Th_comp1 (increase rate increasing threshold) (interval 1). When the sound level (RMS) is equal to or higher than the threshold Th_comp1 and lower than the threshold Th_comp2 (increase rate suppression threshold) (interval 2), the increase rate of the volume of the audio signal is increased compared with that for interval 1 to increase the sound pressure of the audio signal effectively. Moreover, when the sound level (RMS) is equal to or higher than the threshold Th_comp2 (interval 3), the increase rate of the volume of the audio signal is decreased compared with that for interval 1 to suppress an increase in amplitude of the audio signal.

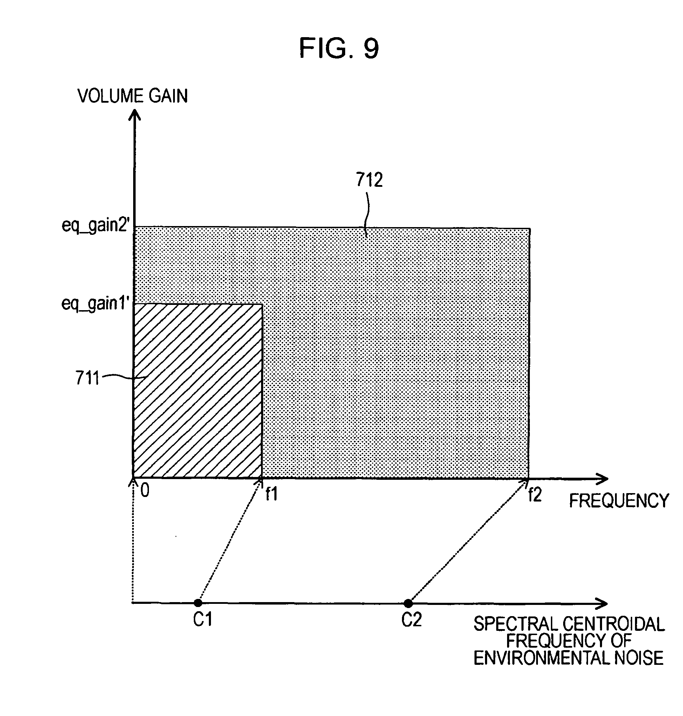

As described above, by using the gain correction characteristic 610, it is possible that the maximum amplitude of the audio signal is suppressed while the sound pressure of the audio signal is effectively increased. Next, a method for adjusting the volume in the case where the audio signal amplified by the compressor processing unit 251 is further amplified in the equalizing processing unit 252, referring to Fig. 9.

[Method example for audio adjustment by the equalizing processing unit]

Fig. 9 is a schematic diagram relating to a method example for adjusting the volume by an equalizing processing unit 252 according to the third embodiment of the present invention. In this drawing, spectral centroids C1 and C2, and volume adjustment areas 711 and 712 corresponding to these centroids are shown. In this drawing, a horizontal axis indicates a frequency and a vertical axis indicates the gain of the volume of the audio signal.

The spectral centroids C1 and C2 are spectral centroidal frequencies calculated in the adjustment band setting unit 260 in accordance with the power spectrum (sp_e) of the environmental noise signal. By calculating the spectral centroids C1 and C2, a high level of frequency component may be identified in the environment noise signal. In this example, the spectral centroid C1 is the spectral centroidal frequency for the first frame of the environment noise signal and the spectral centroid C2 is the spectral centroidal frequency for the second frame.

Volume adjustment frequencies f1 and f2 are the maximum frequencies for the audio signal amplified in the equalizing processing unit 252. The volume adjustment frequencies f1 and f2 are the maximum frequencies obtained by multiplying the spectral centroids C1 and C2 by a certain value.

The set gain eq_gain1' and eq_gain2' are the gains set by the gain setting unit 240. The set gain eq_gain1' is the gain for the first frame of the audio signal and the set gain eq_gain2' is the gain for the second frame.

The volume adjustment areas 711 and 712 are schematic diagrams showing the areas, in which the audio signal is amplified in the equalizing processing unit 252. The volume adjustment area 711 is the amplification area of the volume for the first frame of the audio signal. The volume adjustment area 712 is the amplification area of the volume for the second frame of the audio signal.

As described above, by calculating the frequency bands in which the audio signal is amplified by the equalizing processing unit 252 in accordance with the frequency characteristic of the environmental noise signal, the sound quality may be appropriately adjusted.

<4. Fourth Embodiment>

[Operation example of the recording/reproducing apparatus]

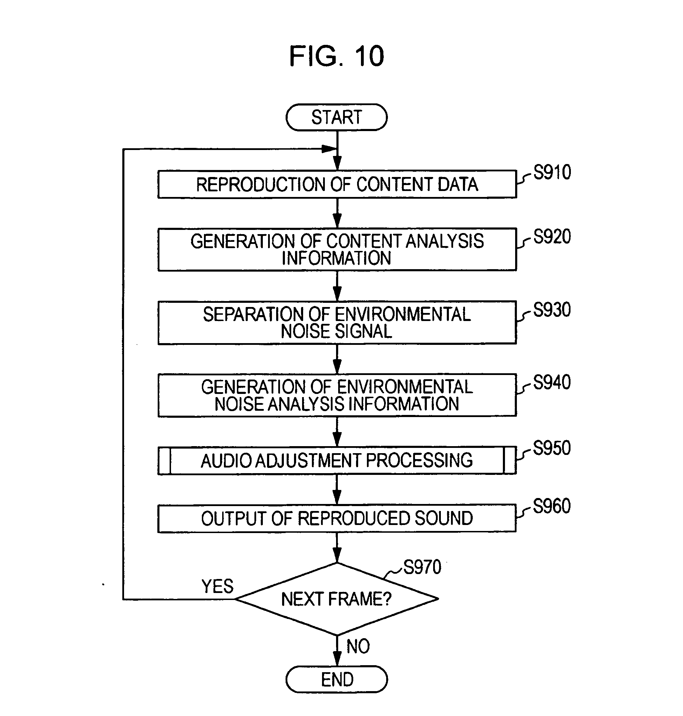

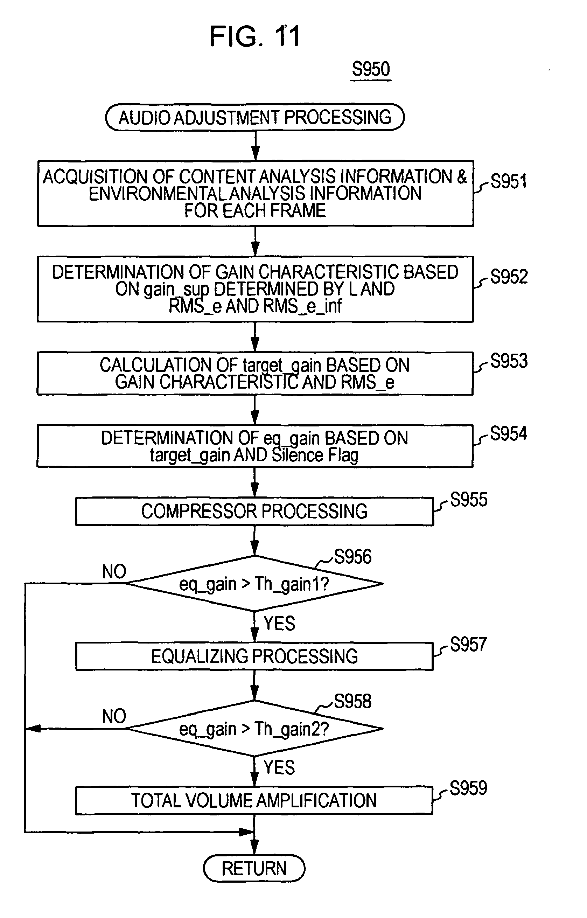

Next, the operation of the recording/reproducing apparatus 100 according to a fourth embodiment of the present invention is described, referring to Figs. 10 and 11.

Fig. 10 is a flowchart illustrating a procedure example for processing audio adjustment by the recording/reproducing apparatus 100 according to a fourth embodiment of the present invention.

First, the content reproducing unit 140 reproduces the content data to generate the audio signal (Step S910). Next, the content analysis information generator 150 generates the content analysis information in accordance with the audio signal from the content reproducing unit 140 (Step S920). The Step S920 is an example of a first procedure for generating the audio adjustment information according to an embodiment of the present invention.

Next, in accordance with the audio signal supplied from the audio adjustment unit 200, the environmental noise separator 180 separates the audio signal output from the speaker 160 and included in the noise signals supplied from the microphone 170 from the environmental noise signal (Step S930). The Step S930 is an example of an audio separation procedure according to an embodiment of the present invention. Next, the environmental noise analysis information generator 190 generates the environmental noise analysis information in accordance with the environmental noise signal separated in the environmental noise separator 180 (Step S940). The Step S940 is an example of the second procedure for generating the audio adjustment information according to an embodiment of the present invention.

Next, in the audio adjustment unit 200, the audio adjustment processing for adjusting the volume of the audio signal is executed in accordance with the content analysis information and the environmental noise analysis information (Step S950). The Step S950 is an example of the audio adjustment procedure according to an embodiment of the present invention. Next, the speaker 160 outputs the audio signal amplified in the audio adjustment unit 200 (Step S960). Next, it is determined whether a frame of a succeeding audio signal is detected (Step S970). If the frame is detected, the sound processing is repeated up to a last frame. If no succeeding frame is detected, the sound processing ends.

[Operation example of the audio adjustment unit]

Fig. 11 is a flowchart illustrating a procedure example for processing audio adjustment (Step S950) by the audio adjustment unit 200 according to the fourth embodiment of the present invention.

First, the content analysis information and the environmental noise analysis information are obtained from the content analysis information generator 150 and the environmental noise analysis information generator 190, respectively (Step S951). Next, the maximum gain acquisition unit 212 acquires the maximum gain (gain_sup) corresponding to the loudness level (L) of the audio signal from the loudness level calculator 156 and the noise level (RMS_e) from the noise level calculator 191. At the same time, the gain characteristic slope determination unit 213 determines the slope of the gain characteristic in accordance with the sound determination information (Speech Flag). The minimum noise level extraction unit 214 extracts the background noise level (RMS_e_inf), which is the lowest noise level among the noise levels (RMS_e) up to the current frame (Step S952). Accordingly, the gain characteristic is generated to calculate the target gain (target_gain).

Next, the target gain calculator 220 calculates the target gain (target_gain) in accordance with the noise level (RMS_e) of the current frame by using the maximum gain, slope, and background noise level in the gain characteristic (Step S953) The adjusted gain calculator 230 calculates the target gain (target_gain) and the adjusted gain (eq_gain) in accordance with the silent sound determination information (Silence Flag) (Step S954).

Next, the gain setting unit 240 sets the gain in the compressor processing unit 251 in accordance with the adjusted gain (eq_gain) and the sound level calculator 151 supplies the sound level (RMS) to the compressor processing unit 251. The compressor processing unit 251 amplifies the audio signal from the content reproducing unit 140 in accordance with the gain set by the gain setting unit 240 and the sound level from the sound level calculator 151 (Step S955).

Next, the gain setting unit 240 determines whether the adjusted gain (eq_gain) is equal to or smaller than the threshold Th_gain1 (Step S956). If the adjusted gain (eq_gain) is equal to or smaller than the threshold Th_gain 1, the audio adjustment processing ends. On the other hand, if the adjusted gain (eq_gain) is larger than the threshold Th_gain1, the gain setting unit 240 sets the gain in the equalizing processing unit 252 in accordance with the adjusted gain (eq-gain). At the same time, the adjustment band setting unit 260 calculates the frequency band in which the audio signal is amplified in accordance with the power spectrum of the environmental noise signal. The equalizing processing unit 252 amplifies the audio signal from the compressor processing unit 251 in accordance with the gain set by the gain setting unit 240 and the frequency band calculated by the adjustment band setting unit 260 (Step S957).

Next, the gain setting unit 240 determines whether the adjusted gain (eq_gain) is equal to or smaller than the threshold Th_gain2 (Step S958). If the adjusted gain (eq_gain) is equal to or smaller than the threshold Th_gain2, the audio adjustment processing ends. On the other hand, the adjusted gain (eq_gain) is larger than the threshold Th_gain2, the gain setting unit 240 sets the gain in the total volume amplifier 253 in accordance with the adjusted gain (eq_gain). The total volume amplifier 253 amplifies the audio signal from the equalizing processing unit 252 in accordance with the gain set by the gain setting unit 240 (Step S959), the audio adjustment processing ends, and the procedure goes to the Step S960.

As described above, according to the embodiments of the present invention, the audio signal of the reproduced content item may be appropriately adjusted in accordance with the content analysis information generated in accordance with the reproduced content and the environmental noise analysis information generated in accordance with the environmental noise signal.

By incorporating the maximum gain acquisition unit 212, the maximum gain and the target gain decrease as the loudness level of the audio signal increases; thereby, the volume of the audio signal may be decreased. The maximum gain increases but the target gain decreases as the noise level increases; thereby, the volume of the audio signal may be increased.

By incorporating the gain characteristic slope determination unit 213, when the audio signal is determined to be non-silent sound, the slope of the gain characteristic increases, that is, the target gain increases; thereby, the output sound may be increased. Accordingly, by increasing the volume of the audio signal determined to be non-silent sound, the output sound is made easier to detect.

In the embodiments of the present invention, examples have been just described to implement the present invention. These examples correspond to specific items according to the embodiments of the present invention. It should be noted that the present invention is not limited to the embodiments of the present invention and thereby, various kinds of modifications may be added to the present invention within the scope of the present invention with no deviation from the subject-matter of the present invention.

The processing procedures described in the embodiments of the present invention may be understood to be a method for providing this series of procedures or may be understood to be a program for executing this series of procedures on a computer or a recording medium storing the program. The recording medium includes, for example, CD (Compact Disc), MD (MiniDisc), DVD, memory card, Blu-ray Disc (registered trademark) and the like.

It should be understood by those skilled in the art that various modifications, combinations, sub-combinations and alterations may occur depending on design requirements and other factors insofar as they are within the scope of the appended claims or the equivalents thereof.

**Claims**

1. A signal processing apparatus (100) comprising:

  a content reproducing unit (140) operable to reproduce an audio signal from a content item;
  a first audio adjustment information generator (150) operable to generate a first audio adjustment information in accordance with an audio signal;
  a sound output unit (160) for outputting the audio signal as sound;
  a sound input unit (170) for capturing ambient sounds comprising the output audio signal and environmental noise;
  an audio separator (180) separating the captured output audio signal from the environmental noise signals;
  a second audio adjustment information generator (190) generating a second audio adjustment information in accordance with the environmental noise signals separated by the audio separator; and

an audio adjustment unit (200) adjusting a volume of the audio signal output in the sound output unit in accordance with the first and second audio adjustment information, the audio adjustment unit comprising a target gain calculator operable to calculate a target gain for the audio adjustment unit corresponding to the environmental noise signals separated by the audio separator; wherein

the first audio adjustment information generator has a sound determination unit (152) determining whether the audio signal is silent sound below a predetermined threshold level; and

when the sound determination unit determines that the audio signal is silent sound, the audio adjustment unit suppresses increases of volume of the audio signal compared to when the sound determination unit determines that the audio signal is non-silent sound above the predetermined threshold level, regardless of the target gain.

2. The signal processing apparatus according to Claim 1, wherein:

the first audio adjustment information generator generates the first audio adjustment information in accordance with frequency characteristic of the audio signal and human auditory characteristics;

the second audio adjustment information generator generates the second audio adjustment information in accordance with the signal levels of the noise signals; and

the audio adjustment unit decreases the volume of the audio signal as the first audio adjustment information becomes large and increases the volume as the second audio adjustment information becomes large.

3. The signal processing apparatus according to Claim 2, wherein:

the first audio adjustment information generator further has a silent sound determination unit determining whether the audio signal is silent sound in accordance with the signal level of the audio signal; and

the audio adjustment unit does not increase the volume of the audio signal when the silent sound determination unit determines the audio signal is silent sound.

4. The signal processing apparatus according to Claim 1, wherein the audio separator calculates similarity between the audio signal and the audio signals included in the noise signals in accordance with the audio signal, and estimates the noise signals in accordance with the calculated similarity.

5. The signal processing apparatus according to Claim 4, wherein the audio separator has an echo canceller.

6. A method for adjusting volume in a signal processing apparatus , the method comprising the steps of:

reproducing an audio signal from a content item;

generating a first audio adjustment information in accordance with the audio signal;

determining whether the audio signal is silent sound below a predetermined threshold level;

outputting the audio signal using a sound output unit;

capturing ambient sound comprising the output audio signal and environmental noise using a sound input unit;

separating the captured output audio signal from the environmental noise signals;

generating a second audio adjustment information in accordance with the environmental noise signals separated in the step of separating the audio signal;

calculating a target gain for audio adjustment corresponding to the environmental noise signals; and

adjusting the volume of the audio signal output into the sound output unit in accordance with the first and second audio adjustment information, and wherein

when the audio signal is determined to be silent sound, increases of volume of the audio signal is suppressed compared to when the audio signal is determined to be non-silent sound above the predetermined threshold level, regardless of the target gain.

7. A computer program for implementing the steps of claim 6.

**Patentansprüche**

1. Signalverarbeitungsvorrichtung (100), die Folgendes umfasst:

eine Inhaltswiedergabeeinheit (140), die betrieben werden kann, um ein Audiosignal aus einem Inhaltseintrag wiederzugeben;

einen ersten Audioeinstellungsinformationsgenerator (150), d e r betrieben werden kann, um erste Audioeinstellungsinformationen gemäß einem Audiosignal zu generieren;

eine Tonausgabeeinheit (160) zum Ausgeben des Audiosignals als Ton;

eine Toneingabeeinheit (170) zum Erfassen von Umgebungstönen, die das ausgegebene Audiosignal und Umgebungsrauschen umfassen;

einen Audioseparator (180), um das erfasste ausgegebene Audiosignal von den Umgebungsrauschsignalen zu trennen;

einen zweiten Audioeinstellungsinformationsgenerator (190), um zweite Audioeinstellungsinformationen gemäß den Umgebungsrauschsignalen, die durch den Audioseparator abgetrennt sind, zu generieren; und

eine Audioeinstellungseinheit (200), um eine Lautstärke des Audiosignals, das in der Tonausgabeeinheit ausgegeben wird, gemäß den ersten und zweiten Audioeinstellungsinformationen einzustellen, wobei die Audioeinstellungseinheit eine Sollverstärkungsberechnungseinheit umfasst, die betrieben werden kann, um eine Sollverstärkung für die Audioeinstellungseinheit entsprechend den Umgebungsrauschsignalen, die von dem Audioseparator abgetrennt wurden, zu berechnen; wobei

der erste Audioeinstellungsinformationsgenerator eine Tonbestimmungseinheit (152) aufweist, die bestimmt, ob das Audiosignal ein leiser Ton unterhalb eines vorgegebenen Schwellenpegels ist; und

dann, wenn die Tonbestimmungseinheit bestimmt, dass das Audiosignal ein leiser Ton ist, die Audioeinstellungseinheit unabhängig von der Sollverstärkung Erhöhungen der Lautstärke des Audiosignals verglichen damit, wenn die Tonbestimmungseinheit bestimmt, dass das Audiosignal ein nicht leiser Ton oberhalb des vorgegebenen Schwellenpegels ist, unterdrückt.

**2.** Signalverarbeitungsvorrichtung nach Anspruch 1, wobei:

der erste Audioeinstellungsinformationsgenerator die ersten Audioeinstellungsinformationen gemäß den Frequenzeigenschaften des Audiosignals und menschlichen Gehöreigenschaften generiert;

der zweite Audioeinstellungsinformationsgenerator die zweiten Audioeinstellungsinformationen gemäß den Signalpegeln der Rauschsignale generiert; und

die Audioeinstellungseinheit die Lautstärke des Audiosignals verringert, wenn die ersten Audioeinstellungsinformationen groß werden, und die Lautstärke erhöht, wenn die zweiten Audioeinstellungsinformationen groß werden.

**3.** Signalverarbeitungsvorrichtung nach Anspruch 2, wobei:

der erste Audioeinstellungsinformationsgenerator ferner eine Bestimmungseinheit für leisen Ton aufweist, die gemäß dem Signalpegel des Audiosignals bestimmt, ob das Audiosignal ein leiser Ton ist; und

die Audioeinstellungseinheit die Lautstärke des Audiosignals nicht erhöht, wenn die Bestimmungseinheit für leisen Ton bestimmt, dass das Audiosignal ein leiser Ton ist.

**4.** Signalverarbeitungsvorrichtung nach Anspruch 1, wobei der Audioseparator Ähnlichkeit zwischen dem Audiosignal und den Audiosignalen, die in den Rauschsignalen enthalten sind, gemäß dem Audiosignal berechnet und die Rauschsignale gemäß der berechneten Ähnlichkeit schätzt.

**5.** Signalverarbeitungsvorrichtung nach Anspruch 4, wobei der Audioseparator einen Echokompensator aufweist.

**6.** Verfahren zum Einstellen der Lautstärke in einer Signalverarbeitungsvorrichtung, wobei das Verfahren die folgenden Schritte umfasst:

Wiedergeben eines Audiosignals aus einem Inhaltseintrag;

Generieren erster Audioeinstellungsinformationen gemäß dem Audiosignal;

Bestimmen, ob das Audiosignal ein leiser Ton unterhalb eines vorgegebenen Schwellenpegels ist;

Ausgeben des Audiosignals unter Verwendung einer Tonausgabeeinheit;

Erfassen von Umgebungston, der das ausgegebene Audiosignal und Umgebungsrauschen umfasst, unter Verwendung einer Toneingangseinheit;

Trennen des erfassten ausgegebenen Audiosignals von den Umgebungsrauschsignalen;

Generieren zweiter Audioeinstellungsinformationen gemäß den Umgebungsrauschsignalen, die im Schritt des Trennens des Audiosignals getrennt wurden;

Berechnen einer Sollverstärkung zur Audioeinstellung entsprechend den Umgebungsrauschsignalen; und

Einstellen der Lautstärke des Audiosignals, das in die Tonausgabeeinheit ausgegeben wird, gemäß den ersten und zweiten Audioeinstellungsinformationen, wobei

dann, wenn bestimmt wird, dass das Audiosignal ein leiser Ton ist, das Erhöhen der Lautstärke des Audiosignals unabhängig von der Sollverstärkung verglichen damit, wenn bestimmt wird, dass das Audiosignal ein nicht leiser Ton oberhalb des vorgegebenen Schwellenpegels ist, unterdrückt wird.

**7.** Computerprogramm zum Implementieren der Schritte nach Anspruch 6.

**Revendications**

**1.** Appareil de traitement de signaux (100) comprenant :

- une unité de reproduction de contenu (140) permettant de reproduire un signal audio à partir d'un objet de contenu ;
- un générateur de premières informations d'ajustement audio (150) afin de générer des premières informations d'ajustement audio en fonction d'un signal audio ;
- une unité de sortie de son (160) afin d'émettre le signal audio sous forme de son ;
- une unité d'entrée de son (170) afin de capturer des sons ambiants comprenant le signal audio émis et un bruit environnemental ;
- un séparateur audio (180) séparant le signal audio émis capturé des signaux de bruit environnemental ;
- un générateur de secondes informations d'ajustement audio (190) générant des secondes informations d'ajustement audio en fonction des signaux de bruit environnemental séparés par le séparateur audio ; et
- une unité d'ajustement audio (200) ajustant un volume du signal audio émis dans l'unité de sortie de son en fonction des premières et secondes informations d'ajustement audio, l'unité d'ajustement audio comprenant un calculateur de gain cible permettant de calculer un gain cible pour l'unité d'ajustement audio correspondant aux signaux de bruit environnemental séparés par le séparateur audio ; dans lequel
- le générateur de premières informations d'ajustement audio comprend une unité de détermination de son (152) déterminant si le signal audio est un son silencieux en dessous d'un niveau seuil prédéterminé ; et
- lorsque l'unité de détermination de son détermine que le signal audio est un son silencieux, l'unité d'ajustement audio supprime les augmentations de volume du signal audio par rapport au cas où l'unité de détermination de son détermine que le signal audio est un son non silencieux au-dessus du niveau seuil prédéterminé, indépendamment du gain cible.

**2.** Appareil de traitement de signaux selon la revendication 1, dans lequel :

- le générateur de premières informations d'ajustement audio génère les premières informations d'ajustement audio en fonction d'une caractéristique de fréquence du signal audio et de caractéristiques d'un auditoire humain ;
- le générateur de secondes informations d'ajustement audio génère les secondes informations d'ajustement audio en fonction des niveaux de signaux des signaux de bruit ; et
- l'unité d'ajustement audio diminue le volume du signal audio lorsque les premières informations d'ajustement audio deviennent importantes, et augmente le volume lorsque les secondes informations d'ajustement audio deviennent importantes.

**3.** Appareil de traitement de signaux selon la revendication 2, dans lequel :

- le générateur de premières informations d'ajustement audio comprend en outre une unité de détermination de son silencieux qui détermine si le signal audio est un son silencieux en fonction du niveau de signal du signal audio ; et
- l'unité d'ajustement audio n'augmente pas le volume du signal audio lorsque l'unité de détermination de son silencieux détermine que le signal audio est un son silencieux.

**4.** Appareil de traitement de signaux selon la revendication 1, dans lequel le séparateur audio calcule la similitude entre le signal audio et les signaux audio compris dans les signaux de bruit en fonction du signal audio, et estime les signaux de bruit en fonction de la similitude calculée.

**5.** Appareil de traitement de signaux selon la revendication 4, dans lequel le séparateur audio est un annuleur d'écho.

6. Procédé pour ajuster le volume dans un appareil de traitement de signaux, lequel procédé comprend les étapes consistant à :

- reproduire un signal audio à partir d'un objet de contenu ;
- générer des premières informations d'ajustement audio en fonction du signal audio ;
- déterminer si le signal audio est un son silencieux en dessous d'un niveau seuil prédéterminé ;
- émettre le signal audio à l'aide d'une unité de sortie de son ;
- capturer un son ambiant comprenant le signal audio émis et un bruit environnemental à l'aide d'une unité d'entrée de son ;
- séparer le signal audio émis capturé des signaux de bruit environnemental ;
- générer des secondes informations d'ajustement audio en fonction des signaux de bruit environnemental séparés lors de l'étape de séparation du signal audio ;
- calculer un gain cible pour l'ajustement audio correspondant aux signaux de bruit environnemental ; et
- ajuster le volume de la sortie de signal audio dans l'unité de sortie de son en fonction des premières et des secondes informations d'ajustement audio ; et dans lequel
- lorsqu'il est déterminé que le signal audio est un son silencieux, les augmentations de volume du signal audio sont supprimées par rapport au cas où il est déterminé que le signal audio est un son non silencieux au-dessus du niveau seuil prédéterminé, indépendamment du gain cible.

7. Programme informatique pour mettre en oeuvre les étapes selon la revendication 6.

# FIG. 1

100

# FIG. 2

# FIG. 3

# FIG. 4

REPRODUCED SOUND
$x[n]$

209

160

180

181

ADAPTIVE FILTER

SPEAKER
OUTPUT SOUND
$y'[n]$

$y[n]$

$-$

$+$

189

$e[n]$

182

170

ENVIRONMENTAL
NOISE
$s[n]$

ENVIRONMENTAL NOISE SEPARATOR

# FIG. 5

310

x[n]

FRAME
INTERVAL
(N SAMPLE)

320

| | FRAME NUMBER | 0 | 1 | 2 | |
|---|---|---|---|---|---|
| 322 | SOUND LEVEL | RMS[0] | RMS[1] | RMS[2] | |
| 323 | SILENT SOUND DETERMINATION INFORMATION | Silence Flag [0] | Silence Flag [1] | Silence Flag [2] | |
| 324 | LOUDNESS LEVEL | L[0] | L[1] | L[2] | |
| 325 | SOUND DETERMINATION INFORMATION | Speech Flag [0] | Speech Flag [1] | Speech Flag [2] | |

321

## FIG. 6

410

e[n]

FRAME
INTERVAL
(N SAMPLE)

420

| | FRAME NUMBER | 0 | 1 | 2 | |
|---|---|---|---|---|---|
| 421 | | | | | |
| 422 | NOISE LEVEL | RMS_e[0] | RMS_e[1] | RMS_e[2] | |
| 423 | POWER SPECTRUM | sp_e[0][1]— sp_e[0][k] | sp_e[1][1]— sp_e[1][k] | sp_e[2][1]— sp_e[2][k] | |

# FIG. 7

# FIG. 8

OUTPUT LEVEL

SOUND LEVEL

610

INTERVAL 1

INTERVAL 2

INTERVAL 3

0  Th_comp1  Th_comp2

# FIG. 9

# FIG. 10

START

REPRODUCTION OF CONTENT DATA — S910

GENERATION OF CONTENT ANALYSIS INFORMATION — S920

SEPARATION OF ENVIRONMENTAL NOISE SIGNAL — S930

GENERATION OF ENVIRONMENTAL NOISE ANALYSIS INFORMATION — S940

AUDIO ADJUSTMENT PROCESSING — S950

OUTPUT OF REPRODUCED SOUND — S960

NEXT FRAME? — S970

YES

NO

END

# FIG. 11

S950

$$\boxed{\text{AUDIO ADJUSTMENT PROCESSING}}$$

↓

| ACQUISITION OF CONTENT ANALYSIS INFORMATION & ENVIRONMENTAL ANALYSIS INFORMATION FOR EACH FRAME | S951 |

↓

| DETERMINATION OF GAIN CHARACTERISTIC BASED ON gain_sup DETERMINED BY L AND RMS_e AND RMS_e_inf | S952 |

↓

| CALCULATION OF target_gain BASED ON GAIN CHARACTERISTIC AND RMS_e | S953 |

↓

| DETERMINATION OF eq_gain BASED ON target_gain AND Silence Flag | S954 |

↓

| COMPRESSOR PROCESSING | S955 |

↓

S956

NO ◇ eq_gain > Th_gain1?

↓ YES

| EQUALIZING PROCESSING | S957 |

↓

S958

NO ◇ eq_gain > Th_gain2?

↓ YES

| TOTAL VOLUME AMPLIFICATION | S959 |

↓

$$\boxed{\text{RETURN}}$$

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007053510 A
- JP 3286981 B
- US 20050015252 A
- WO 2006047600 A